# EUROPÄISCHE PATENTSCHRIFT

(11) **EP 3 357 131 B1**
(45) Veröffentlichungstag und Bekanntmachung des Hinweises auf die Patenterteilung: **14.12.2022**
(21) Anmeldenummer: 16774942.3
(22) Anmeldetag: 29.09.2016
(51) Int. Cl.: H01S 5/02, H01S 5/22

(54) **OPTOELEKTRONISCHES BAUELEMENT**
OPTOELECTRONIC COMPONENT
COMPOSANT OPTOÉLECTRONIQUE

(30) Priorität: 01.10.2015 DE 102015116712
(43) Veröffentlichungstag der Anmeldung: 08.08.2018
(60) Teilanmeldung: 22201865.7
(73) Patentinhaber: OSRAM Opto Semiconductors GmbH, 93055 Regensburg (DE)
(72) Erfinder: GERHARD, Sven, 93087 Alteglofsheim (DE); LELL, Alfred, 93142 Maxhütte-Haidhof (DE); VIERHEILIG, Clemens, 93105 Tegernheim (DE); LOEFFLER, Andreas, 93073 Neutraubling (DE)
(74) Vertreter: Patentanwaltskanzlei WILHELM & BECK
(86) Internationale Anmeldenummer: PCT/EP2016/073326
(87) Internationale Veröffentlichungsnummer: WO 2017/055490

(56) Entgegenhaltungen:
- EP-A2- 1 496 584
- JP-A- 2006 165 407
- JP-A- 2006 186 025
- US-A1- 2007 264 802
- US-A1- 2009 137 098

## Beschreibung

Die Erfindung betrifft ein optoelektronisches Bauelement gemäß Patentanspruch 1.

Diese Patentanmeldung beansprucht die Priorität der deutschen Patentanmeldung DE 10 2015 116 712. 3.

Im Stand der Technik sind optoelektronische Bauelemente beispielsweise in Form von Laserdioden aus US 2009/0137098 A1 oder aus US 7 724 793 B2 bekannt, die eine Schichtstruktur mit einer aktiven Zone zum Erzeugen einer elektromagnetischen Strahlung aufweisen. Auf der Schichtstruktur ist eine Ridgestruktur angeordnet, die zwischen zwei parallel zueinander angeordneten Seitenflächen angeordnet ist.

Aus JP 2006 165407 A ist ein optoelektronisches Bauelement mit einer Schichtstruktur mit einer aktiven Zone zum Erzeugen einer elektromagnetischen Strahlung bekannt, wobei die Schichtstruktur eine Oberseite und vier Seitenflächen aufweist, wobei die erste und die dritte Seitenfläche gegenüberliegend angeordnet sind, wobei die zweite und die vierte Seitenfläche gegenüberliegend angeordnet sind, wobei eine streifenförmige Ridgestruktur auf der Oberseite der Schichtstruktur angeordnet ist. Die Ridgestruktur erstreckt sich zwischen der ersten Seitenfläche und der dritten Seitenfläche. Die erste Seitenfläche stellt eine Abstrahlfläche für elektromagnetische Strahlung dar. Seitlich neben der Ridgestruktur ist in die Oberseite der Schichtstruktur eine erste Ausnehmung eingebracht. Zudem ist eine zweite Ausnehmung in die erste Ausnehmung eingebracht, wobei sich die zweite Ausnehmung bis zu der zweiten Seitenfläche erstreckt.

Die Aufgabe der Erfindung besteht darin, ein verbessertes optoelektronisches Bauelement bereitzustellen. Die Aufgabe der Erfindung wird durch das Bauelement gemäß Anspruch 1 gelöst.

Weitere vorteilhafte Ausführungsformen sind in den abhängigen Ansprüchen angegeben.

Es wird ein optoelektronisches Bauelement mit einer Schichtstruktur mit einer aktiven Zone zum Erzeugen einer elektromagnetischen Strahlung bereitgestellt, wobei die Schichtstruktur eine Oberseite und vier Seitenflächen aufweist, wobei eine streifenförmige Ridgestruktur auf der Oberseite der Schichtstruktur angeordnet ist, wobei sich die Ridgestruktur zwischen der ersten Seitenfläche und der dritten Seitenfläche erstreckt, wobei die erste Seitenfläche eine Abstrahlfläche für elektromagnetische Strahlung darstellt, wobei seitlich neben der Ridgestruktur in die Oberseite der Schichtstruktur eine erste Ausnehmung eingebracht ist, wobei eine zweite Ausnehmung in die erste Ausnehmung eingebracht ist, und wobei die zweite Ausnehmung sich bis zu der zweiten Seitenfläche erstreckt. Dadurch wird die Ausbildung von Versetzungen beim Brechen der ersten und/oder der dritten Seitenfläche weitgehend vermieden. Zudem wird bei einer p-down Montage ein über die Seitenfläche fließender Leckstrom reduziert.

Die erste Ausnehmung erstreckt sich über eine gesamte Länge der Laserdiode von der ersten bis zur dritten Seitenfläche entlang der zweiten Seitenfläche, wobei sich die erste Ausnehmung bis zu der zweiten Seitenfläche erstreckt, wobei die zweite Ausnehmung in eine erste Bodenfläche der ersten Ausnehmung eingebracht ist, wobei sich die zweite Ausnehmung entlang der zweiten Seitenfläche erstreckt, wobei die zweite Ausnehmung beabstandet von der ersten Seitenfläche und beabstandet von der dritten Seitenfläche ausgebildet ist, und wobei die zweite Ausnehmung in die zweite Seitenfläche mündet.

In einer Ausführungsform ist die erste Ausnehmung in die erste Seitenfläche und/oder in die dritte Seitenfläche eingebracht, wobei die zweite Ausnehmung in die erste Seitenfläche und/oder in die dritte Seitenfläche eingebracht ist. Durch die Anordnung der ersten und/oder der dritten Ausnehmung im Bereich der ersten und/oder der dritten Seitenfläche kann eine weitere Reduzierung der Ausbildung von Versetzungen beim Brechen der ersten und/oder der dritten Seitenfläche erreicht werden.

In einer Ausführungsform ist wenigstens eine dritte Ausnehmung seitlich neben der Ridgestruktur in eine Bodenfläche der ersten Ausnehmung eingebracht ist. Dadurch kann eine weitere Reduzierung der Ausbildung von Versetzungen beim Brechen der ersten und/oder der dritten Seitenfläche erreicht werden.

In einer Ausführungsform ist die dritte Ausnehmung in die erste und/oder in die dritte Seitenfläche eingebracht ist. Dadurch wird eine weitere Reduzierung der Ausbildung von Versetzungen beim Brechen der ersten und/oder der dritten Seitenfläche erreicht.

In einer Ausführungsform ist die dritte Ausnehmung im Wesentlichen parallel zu der zweiten Seitenfläche angeordnet ist, wobei die dritte Ausnehmung beabstandet zu der ersten Seitenfläche und beabstandet zu der dritten Seitenfläche angeordnet ist.

In einer Ausführungsform erstreckt sich die zweite Ausnehmung über einen Bereich von 1% bis 99%, insbesondere von 50% bis 95% einer Längsseite der ersten Seitenfläche. Auf diese Weise wird eine weitere Reduzierung von über die zweite Seitenfläche fließenden Leckströme bei einer p-down Montage erreicht.

In einer Ausführungsform weist die zweite Ausnehmung eine größere Tiefe bezogen auf eine Bodenfläche der ersten Ausnehmung als die dritte Ausnehmung auf.

In einer Ausführungsform weist die zweite Ausnehmung eine Tiefe im Bereich zwischen 0,5 µm und 50 µm, insbesondere im Bereich zwischen 1µm und 10pm bezogen auf die Oberseite 7 auf. Auf diese Weise wird eine ausreichende Reduzierung von über die zweite Seitenfläche fließenden Leckströme bei einer p-down Montage reduziert.

In einer Ausführungsform weist die zweite Ausnehmung eine Tiefe im Bereich zwischen 2 µm und 6 µm bezogen auf die Oberseite 7 auf.

In einer Ausführungsform sind die zweite und die vierte Seitenfläche spiegelsymmetrisch in Bezug auf eine Mittenebene ausgebildet, wobei die auf gegenüber liegenden Seiten bezüglich der Ridgestruktur angeordneten Oberseiten spiegelsymmetrisch in Bezug auf die Mittenebene ausgebildet sind. Somit werden Leckströme über die zweite und die dritte Seitenfläche reduziert. Weiterhin wird die Ausbildung von Versetzungen an der ersten und/oder an der dritten Seitenfläche weiter reduziert.

In einer Ausführungsform sind wenigstens Wände und/oder Bodenflächen der ersten Ausnehmung und/oder der zweiten Ausnehmung und/oder der dritten Ausnehmung mit einer Passivierungsschicht bedeckt. Dadurch können Leckströme über die Seitenflächen reduziert werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei
Fig. 1 eine schematische perspektivische Darstellung eines optoelektronischen Bauelementes;
Fig. 2 einen Querschnitt durch eine Laserdiode mit zwei Ausnehmungen,
Fig. 3 einen Querschnitt durch eine Laserdiode mit drei Ausnehmungen,
Fig. 4 eine schematische Draufsicht auf eine Oberseite der Laserdiode,
Fig. 5 einen schematischen Querschnitt durch eine Laserdiode mit einer abgeschrägten Ausnehmung;
Fig. 6 einen schematischen Querschnitt durch eine weitere Ausführungsform einer Laserdiode mit einer Ausnehmung, die teilweise senkrecht und teilweise abgeschrägt ausgebildet ist,
Fig. 7 einen schematischen Querschnitt durch eine weitere Ausführungsform einer Laserdiode mit mehreren dritten Ausnehmungen;
Fig. 8 einen Querschnitt durch eine weitere Ausführungsform einer Laserdiode mit einer teilweise senkrechten und teilweise abgeschrägten Flanke;
Fig. 9 eine schematische perspektivische Darstellung einer weiteren Ausführungsform einer Laserdiode mit einer Ausnehmung an der zweiten Seitenflanke;
Fig. 10 eine schematische perspektivische Darstellung einer weiteren Ausführungsform einer Laserdiode mit einer Ausnehmung auf der dritten Seitenfläche;
Fig. 11 eine schematische perspektivische Darstellung einer Laserdiode mit einer Ausnehmung auf der dritten Seitenfläche und auf der ersten Seitenfläche,
Fig. 12 eine schematische Draufsicht auf einen Teil eines Wafers mit Bauelementen gemäß Fig. 9 vor dem Vereinzeln der Bauelemente,
Fig. 13 eine schematische Draufsicht auf einen Teil eines Wafers mit einer weiteren Ausführungsform von Bauelementen vor dem Vereinzeln der Bauelemente,
Fig. 14 eine schematische Draufsicht auf einen Teil eines Wafers mit Bauelementen gemäß Fig. 10 vor dem Vereinzeln der Bauelemente, und
Fig. 15 eine schematische Draufsicht auf einen Teil eines Wafers mit Bauelementen gemäß Fig. 11 vor dem Vereinzeln der Bauelemente.

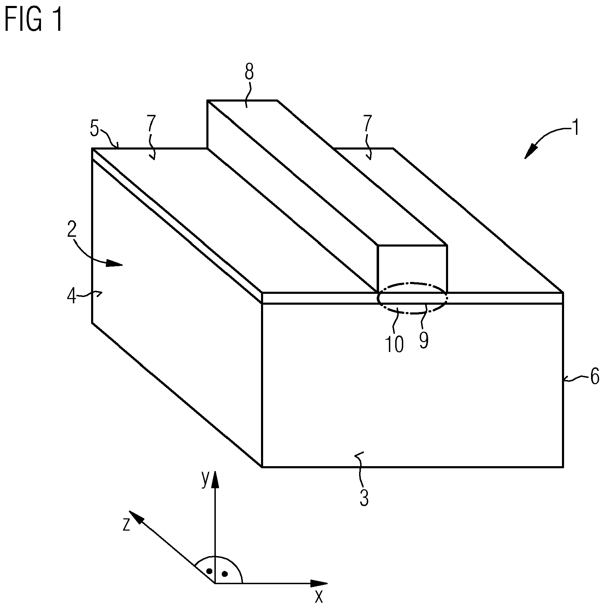

Fig. 1 zeigt in einer schematischen Darstellung ein optoelektronisches Bauelement in Form einer Laserdiode 1, die eine Schichtstruktur 2 aufweist. Die Schichtstruktur 2 weist vier Seitenflächen 3, 4, 5, 6 auf. In der Regel sind die erste Seitenfläche 3 und die dritte Seitenfläche 5 parallel zueinander angeordnet. Ebenso sind in der Regel die zweite Seitenfläche 4 und die vierte Seitenfläche 6 parallel zueinander angeordnet. Auf einer Oberseite 7 der Schichtstruktur 2 ist eine streifenförmige Ridgestruktur 8 angeordnet. Die Ridgestruktur 8 erstreckt sich in Längsrichtung zwischen der ersten und der dritten Seitenfläche 3,5. An der ersten Seitenfläche 3 ist unter der Ridgestruktur 8 eine Abstrahlfläche 7 vorgesehen, über die elektromagnetische Strahlung auf der ersten Seitenfläche 3 abgegeben wird.

In einem Koordinatensystem mit einer x-Achse, einer y-Achse und einer z-Achse, die jeweils senkrecht aufeinander stehen, sind die erste und die dritte Seitenfläche 3, 5 senkrecht zur z-Achse angeordnet. Die zweite und die vierte Seitenfläche 4, 6 sind senkrecht zur x-Achse angeordnet. Die Oberseite 7 ist senkrecht zur y-Achse angeordnet. Die Ridgestruktur 8 ist in dem dargestellten Ausführungsbeispiel mittig in Bezug auf eine Breite entlang der x-Achse der Oberseite 7 angeordnet. Die Ridgestruktur deckt nur einen Teil der Breite der Oberseite 7 ab. Die Ridgestruktur 8 erstreckt sich entlang der z-Achse in dem dargestellten Ausführungsbeispiel senkrecht zur ersten Seitenfläche 3 von der ersten Seitenfläche 3 bis zur dritten Seitenfläche 5. Abhängig von der gewählten Ausführungsform kann die Ridgestruktur 8 auch vor der Ebene der ersten und/oder der dritten Seitenfläche 3, 5 enden oder in einem Winkel ungleich 90° zu der Ebene der ersten und/oder der dritten Seitenfläche 3, 5 ausgerichtet sein. Die erste und die dritte Seitenfläche können Spiegelschichten aufweisen. Zudem kann auf der Oberseite 7 eine Isolationsschicht angeordnet sein.

Das optoelektronisches Bauelement ist beispielsweise als kantenemittierende Laserdiode oder als Licht emittierende Diode (LED) ausgebildet. Insbesondere kann die Laserdiode/LED aus einem III-V-Halbleitermaterial, insbesondere aus Indiumgalliumnitrid, hergestellt werden. Die Schichtstruktur 2 weist eine aktive Zone 9 auf, die senkrecht zur y-Achse in einer Ebene angeordnet ist und sich seitlich entlang der x-Achse über die Breite der Ridgestruktur hinaus erstecken kann. Aufgrund der Ridgestruktur 8 wird eine Führung einer erzeugten Lasermode 10 unter der Ridgestruktur 8 in der aktiven Zone 9 erreicht. Die Schichtstruktur 2 kann aus einem III-V Halbleitermaterial bestehen und auf einem Träger angeordnet sein. Das Substrat und/oder die Schichtstruktur 2 können auf einem III-V-Verbindungshalbleiter oder einem II-VI-Verbindungshalbleiter oder Zinkoxid basieren. Der II-VI-Verbindungshalbleiter kann ein Sulfid oder ein Selenid sein. Der III-V-Verbindungshalbleiter kann auf einem Nitrid-Verbindungshalbleiter, einem Phosphid-Verbindungshalbleiter, einem Antimonit-Verbindungshalbleiter oder einem Arsenid-Verbindungshalbleiter basieren. Der III-V-Verbindungshalbleiter kann beispielsweise ein Nitrid wie etwa Galliumnitrid, Indiumnitrid oder Aluminiumnitrid, ein Phosphid wie etwa Galliumphosphid oder Indiumphosphid ein ersten Arsenid wie etwa Galliumarsenid oder Indiumarsenid sein. Dabei kann beispielsweise das Materialsystem AlₙIn₁₋ₙ₋ₘGaₘN vorgesehen sein, wobei 0 ≤ n ≤ 1, 0 ≤ m ≤ 1 und n+m ≤ 1 sein kann. Zudem kann das Materialsystem AlₙGaₘIn₁₋ₙ₋ₘP umfassen, wobei 0 ≤ n ≤ 1, 0 ≤ m ≤ 1 und n+m ≤ 1 ist. Zudem kann das Materialsystem AlₙGaₘIn₁₋ₙ₋ₘSb umfassen, wobei 0 ≤ n ≤ 1, 0 ≤ m ≤ 1 und n+m ≤ 1 ist.

Bei der Herstellung der Laserdiode 1 werden einzelne Laserdioden 1 aus einem Verbund, insbesondere aus einem Wafer herausgelöst, wobei insbesondere die erste und die dritte Seitenfläche 3, 5 mithilfe eines Brechens des Wafers erzeugt werden. Die erste und die dritte Seitenfläche 3, 5 sollten für eine gute Qualität der Laserdiode 1 festgelegte Bedingungen erfüllen, insbesondere eine plane Fläche ohne Störungen und Versetzungen darstellen. Deshalb ist das Brechen der ersten und der dritten Seitenfläche 3, 5 ein wichtiger Prozess für die Qualität der Laserdiode 1.

Im Folgenden werden verschiedene Strukturen dargestellt, mit denen ein Brechen der ersten und der dritten Seitenfläche 3, 5 ermöglicht wird, wobei eine hohe Güte der ersten und der dritten Seitenfläche 3, 5 erzeugt wird.

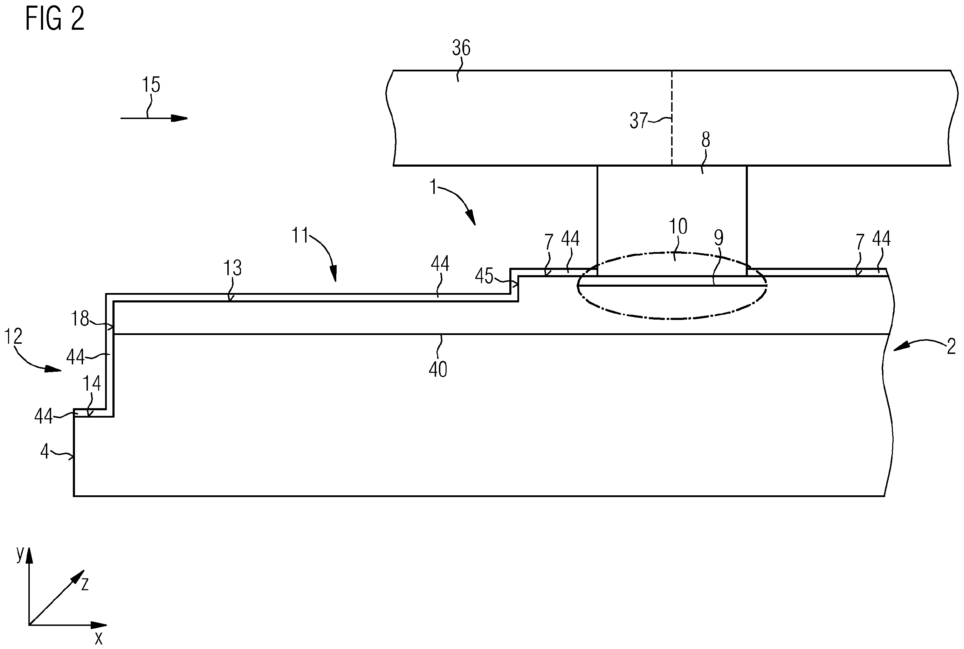

Fig. 2 zeigt einen schematischen Teilquerschnitt durch eine Anordnung mit einer ersten Ausführungsform einer Laserdiode 1 in der X-Y Ebene, die in p-down Montage mit der Ridgestruktur 8 an einem Träger 36 befestigt ist. Der Träger 36 kann in Form eines Halbleitersubstrates ausgebildet sein. In der Schichtstruktur 2 ist die aktive Zone 9 angeordnet, wobei mithilfe der Ridgestruktur 8 im Betrieb der Laserdiode 1 eine Lasermode 10 unter der Ridgestruktur 8 erzeugt werden. Die Lasermode 10 wird von der dritten Seitenfläche 5 reflektiert und über die erste Seitenfläche 3 wenigstens teilweise emittiert.

Die Schichtstruktur 2 weist zwischen der Ridgestruktur 8 und der zweiten Seitenfläche 4 in der Oberseite 7 eine erste Ausnehmung 11 auf, die sich in der x-Achse in Richtung auf die zweite Seitenfläche 4 bis zu einer zweiten Ausnehmung 12 erstreckt. Die erste Ausnehmung 11 weist eine erste Bodenfläche 13 auf und erstreckt sich in Längsrichtung, das heißt entlang der z-Achse beispielsweise von der ersten Seitenfläche 3 bis zur dritten Seitenfläche 5. Abhängig von der gewählten Ausführungsform kann sich die erste Ausnehmung 11 auch nur über einen Teil der Länge des Bauelementes erstrecken.

Die erste Bodenfläche 13 und Seitenflächen 45 der ersten Ausnehmung 11 sind in einer Ausführungsform mit einer elektrisch isolierenden Passivierungsschicht 44 versehen. Die Passivierungsschicht 44 ist beispielsweise als Oxidschicht ausgebildet und kann beispielsweise vor dem Vereinzeln der Laserdioden in einem Oxidationsverfahren mit Sauerstoffplasma oder Wasserdampf bei erhöhten Temperaturen erzeugt werden. Die erste Bodenfläche 13 und die Seitenfläche 45 der ersten Ausnehmung 11 sind beispielsweise aus Silizium aufgebaut, so dass die Passivierungsschicht aus Siliziumoxid gebildet sein kann. Zudem kann die Passivierungsschicht auch aus SiNₓ, TiO₂ oder Ta₂O₅ gebildet sein.

Die zweite Ausnehmung 12 erstreckt sich von der ersten Bodenfläche 13 der ersten Ausnehmung 11 über eine Wandfläche 18 entlang der Y-Achse bis zu einer zweiten Bodenfläche 14. Die Wandfläche 18 und die zweite Bodenfläche 14 können ebenfalls mit der Passivierungsschicht 44 bedeckt sein. Die zweite Ausnehmung 12 kann sich in der z-Achse von der ersten Seitenfläche 3 bis zur dritten Seitenfläche 5 erstrecken. Zudem kann sich die zweite Ausnehmung 12 entlang der Z-Achse nur über einen Teil der Länge der Laserdiode erstrecken.

Die erste Bodenfläche 13 ist entlang der Y-Achse beispielsweise im Bereich der Ebene angeordnet, in der die aktive Zone 9 angeordnet ist. Beim Brechen wird die Schichtstruktur 2, die als Halbleiterschichtstruktur ausgebildet ist, in einer Bruchrichtung 15 von links nach rechts senkrecht zur z-Achse gebrochen. Aufgrund der ersten und der zweiten Ausnehmung 11, 12 werden dabei Querfacetten und/oder Störungen an der ersten Seitenfläche 3 vermieden bzw. in einen Bereich unterhalb der Lasermode 10 abgelenkt. Zudem können die zweite und/oder die vierte Seitenfläche 4,6 ebenfalls mit Brechverfahren oder Sägeverfahren oder Ätzverfahren hergestellt werden.

Es ist schematisch eine Versetzung 40 dargestellt, die von der Wandfläche 18 der zweiten Ausnehmung 12 ausgeht und entlang der X-Achse quer über die Breite der Laserdiode 1 läuft. Die Versetzung 40 ist jedoch unterhalb der Lasermode 10 angeordnet und kann somit die Qualität der von der Laserdiode 1 abgegebenen elektromagnetischen Strahlung nicht beeinträchtigen.

Die Oberseite 7 kann auf beiden Seiten der Ridgestruktur 8 in Bezug auf eine Mittenebene 37 spiegelsymmetrisch ausgebildet sein. Die Mittenebene 37 ist parallel zur Y-Z-Ebene und mittig in der X-Richtung in der Ridgestruktur 8 angeordnet. Die vierte Seitenfläche 6 kann ebenso spiegelsymmetrisch zu der Mittenebene 37 ausgebildet sein. Somit ist vierte Seitenfläche 6 gemäß der zweiten Seitenfläche 4 mit entsprechenden Ausnehmungen 11,12 versehen.

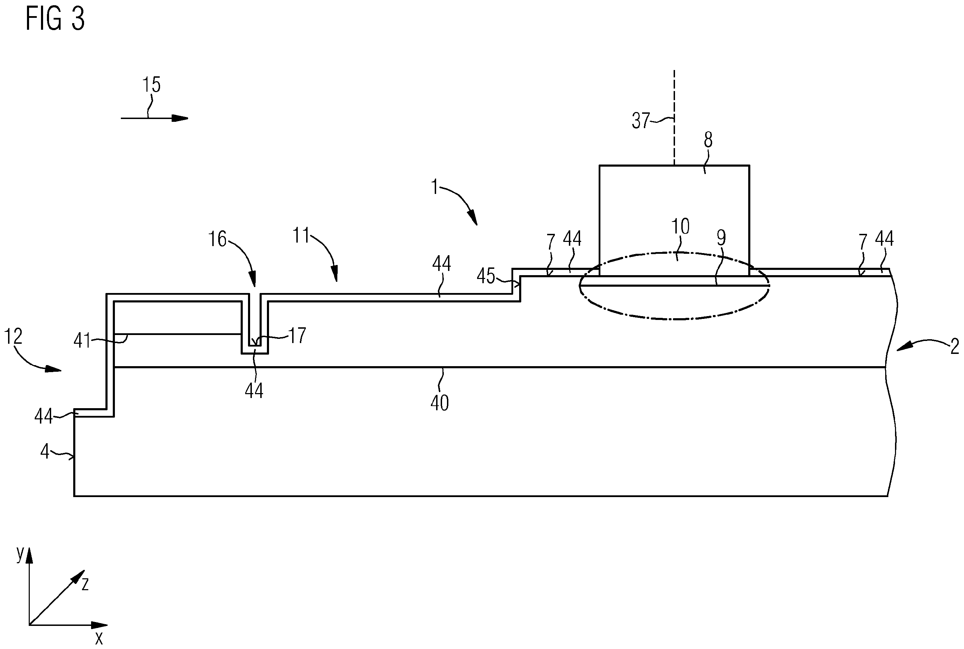

Fig. 3 zeigt einen schematischen Teilquerschnitt einer weiteren Ausführungsform einer Laserdiode 1 in der X-Y Ebene, wobei zusätzlich zu der ersten und der zweiten Ausnehmung 11, 12 eine dritte Ausnehmung 16 vorgesehen ist. Die dritte Ausnehmung 16 ist entlang der x-Achse zwischen der Ridgestruktur 8 und der zweiten Ausnehmung 12 in die Bodenfläche 13 der ersten Ausnehmung 11 eingebracht. Abhängig von der gewählten Ausführungsform kann die dritte Ausnehmung 16 eine geringere Tiefe als die zweite Ausnehmung 12 aufweisen. Ebenfalls kann eine dritte Bodenfläche 17 der dritten Ausnehmung 16 wenigstens im Bereich der Ebene der aktiven Zone 9 oder unterhalb der Ebene der aktiven Zone 9 angeordnet sein. Die dritte Ausnehmung 16 kann sich über die gesamte Länge in Z-Richtung der Laserdiode 1 oder nur über einen Teilabschnitt erstrecken. Zudem können Seitenwände und dritte Bodenfläche 17 der dritten Ausnehmung 16 mit einer Passivierungsschicht 44 bedeckt sein. Mithilfe der dritten Ausnehmung 16 kann beim Brechen der Schichtstruktur 2 in der Bruchrichtung 15 von links nach rechts eine weitere Verbesserung der Güte der ersten Seitenfläche 3 erreicht werden.

Mithilfe der dritten Ausnehmung 16 können ebenfalls in einem tieferen Bereich entstehende Querfacetten oder Störungen, die beim Brechen erzeugt werden, abgefangen werden. Es ist schematisch eine Versetzung 40 dargestellt, die von der zweiten Ausnehmung 12 ausgeht und entlang der X-Achse quer über die Breite der Laserdiode verläuft. Die Versetzung 40 ist jedoch unterhalb der Lasermode 10 angeordnet und kann somit die Qualität der Laserstrahlung nicht beeinträchtigen. Zudem ist eine zweite Versetzung 41 dargestellt, die von der zweiten Ausnehmung 12 ausgeht und entlang der X-Achse quer bis zur dritten Ausnehmung 16 läuft. Die dritte Ausnehmung 16 verhindert die weitere Ausbildung der zweiten Versetzung 41 in Richtung auf einen Bereich der Lasermode 10.

Die erste, zweite und/oder dritte Ausnehmung 11, 12, 16 können abhängig von der gewählten Ausführungsform nur im Bereich der ersten und der dritten Seitenfläche 3,5 angeordnet sein und sich nicht über die gesamte Länge der Laserdiode in der z-Achse erstrecken. In einer weiteren Ausführung können die erste, die zweite und/oder die dritte Ausnehmung 11, 12, 16 abhängig von der gewählten Ausführungsform im Bereich der ersten und der dritten Seitenfläche 3,5 angeordnet sein und sich über die gesamte Länge der Laserdiode 1 entlang der z-Achse erstrecken. In einer weiteren Ausführung können die erste, die zweite und/oder die dritte Ausnehmung 11, 12, 16 abhängig von der gewählten Ausführungsform nur im Bereich der ersten und der dritten Seitenfläche 3,5 angeordnet sein.

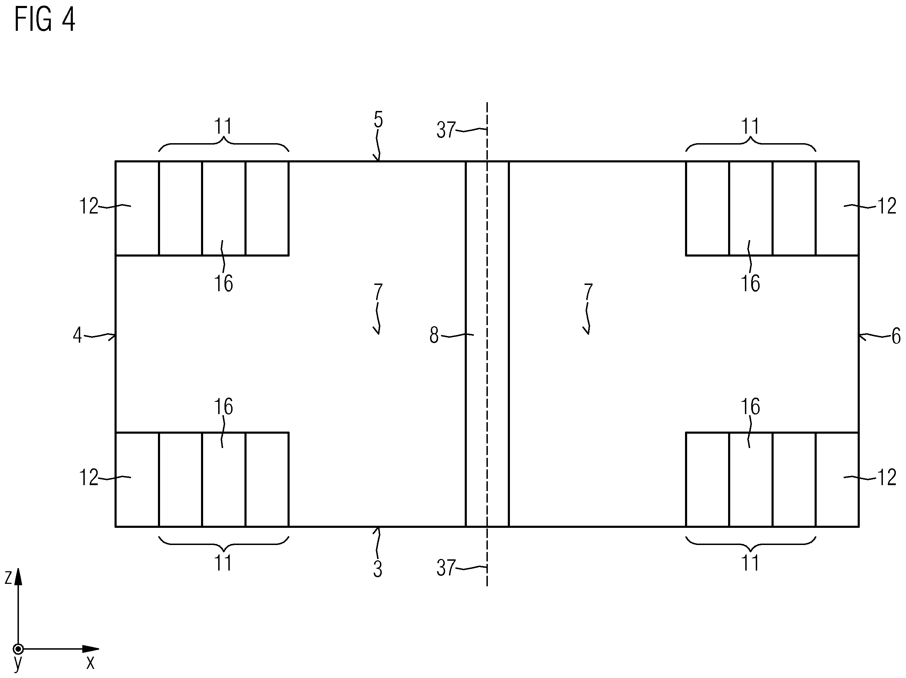

Fig. 4 zeigt in einer schematischen Ansicht von oben einen Blick auf die Ausführungsform der Fig. 3, wobei die erste, die zweite und die dritte Ausnehmung 11, 12, 16 nur angrenzend an die erste und die dritte Seitenfläche 3, 5 ausgebildet sind. Abhängig von der gewählten Ausführungsform können sich die erste, zweite und dritte Ausnehmung 11, 12, 16 auch über die gesamte Länge entlang der z-Achse der Schichtstruktur 2 erstrecken. Die Oberseite 7 und die zweite und vierte Seitenfläche 4,6 sind spiegelsymmetrisch zur Mittenebene 37 ausgebildet. Die Passivierungsschicht ist nicht explizit dargestellt.

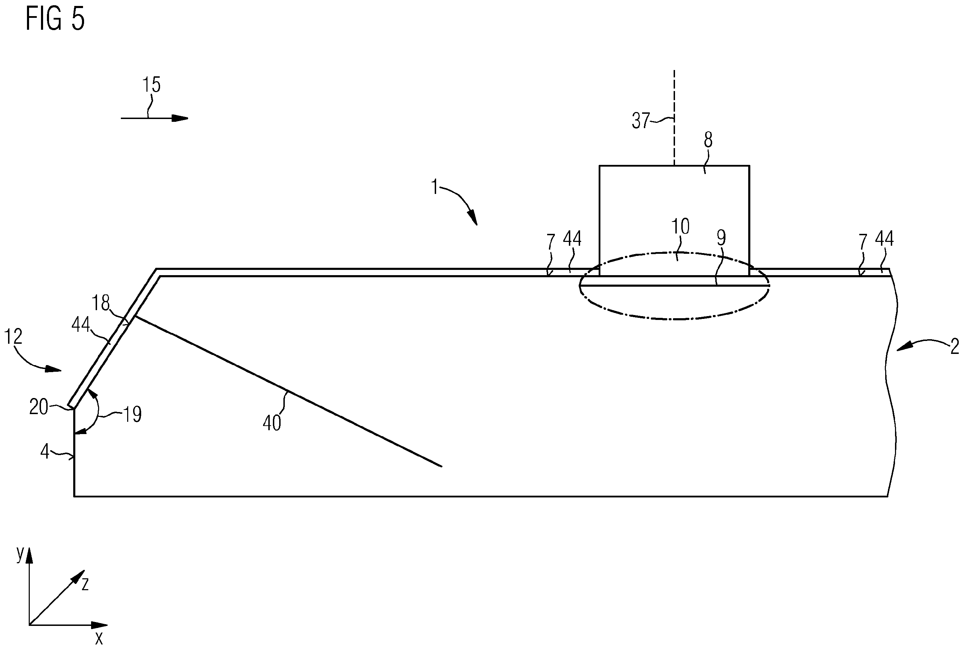

Fig. 5 zeigt einen schematischen Teilquerschnitt in der X-Y Ebene durch eine weitere Ausführungsform einer Laserdiode 1, wobei angrenzend an die zweite Seitenfläche 4 eine zweite Ausnehmung 12 in die Oberseite 7 der Schichtstruktur 2 eingebracht ist. Die zweite Ausnehmung 12 weist eine geneigt angeordnete Wandfläche 18 auf. Die Wandfläche 18 kann in einem Winkel 19 zwischen 91° und 179° bezogen auf die y-Achse ausgerichtet sein. Insbesondere kann die Wandfläche 18 in einem Winkel 19 in Bezug auf die y-Achse angeordnet sein, der zwischen 135° und 155° liegt. Die zweite Ausnehmung 12 kann eine Tiefe im Bereich von 0,5 bis 50 µm bezogen auf die Oberseite 7 aufweisen. Insbesondere kann die Tiefe der Ausnehmung 12 im Bereich von 1 bis 10 µm, insbesondere im Bereich von 2 bis 6 µm liegen. Als Tiefe wird bei dieser Ausführungsform der zweiten Ausnehmung 12 eine Höhe einer Kante 20 auf der Y-Achse angesehen, in der die Wandfläche 18 in die zweite Seitenfläche 4 übergeht. Die Kante 20 ist entlang der Z-Achse ausgerichtet. Da Versetzungen 40 bevorzugt senkrecht zu Flächen loslaufen, ist es möglich, Störungen und Querfacetten durch eine abgeschrägte zweite Seitenfläche 4 nach unten abzuleiten, wie schematisch dargestellt. Die Oberseite 7 und die Wandfläche 18 können mit einer Passivierungsschicht 44 bedeckt sein. Zudem kann die vierte Seitenfläche 6 der Laserdiode 1 spiegelsymmetrisch zur zweiten Seitenfläche 4 in Bezug auf die Mittenebene 37 ausgebildet sein.

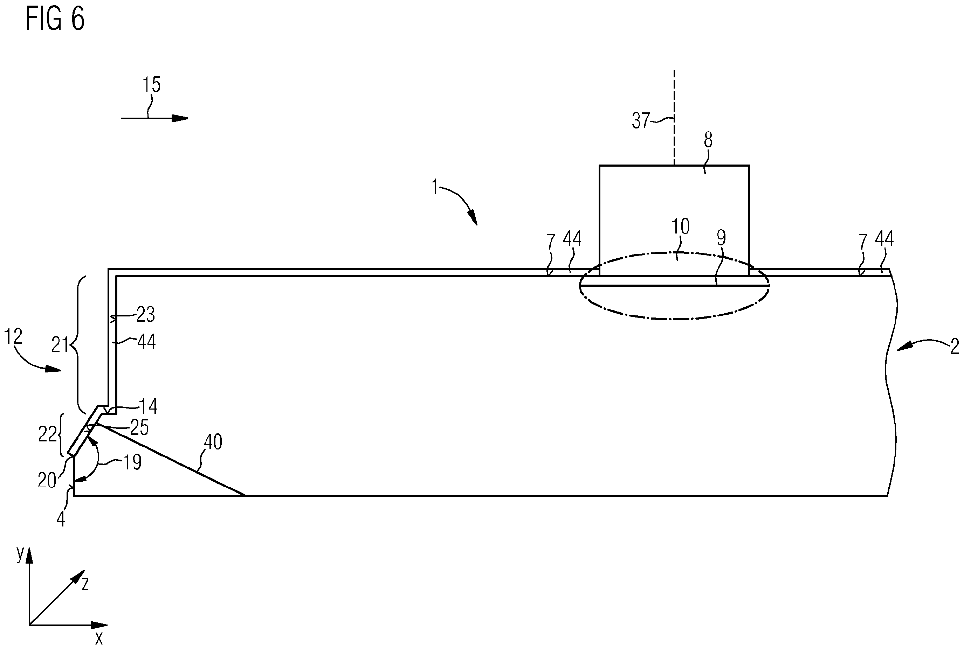

Fig. 6 zeigt einen Teilquerschnitt durch eine weitere Ausführungsform einer Laserdiode 1 in der Y-X Ebene mit einer zweiten Ausnehmung 12, die an der zweiten Seitenfläche 4 in einem oberen Abschnitt 21 eine erste Wandfläche 23 aufweist, die parallel zur y-Achse angeordnet ist. Die erste Wandfläche 23 geht in eine zweite Bodenfläche 14 über. Die zweite Bodenfläche 14 erstreckt sich nicht bis zu der zweiten Seitenfläche 4 in der x-Achse, sondern geht in eine zweite Wandfläche 25 in einem unteren Abschnitt 22 über.

Die zweite Wandfläche 25 ist in Form einer geneigten Fläche ausgebildet, die einen Winkel 19 in Bezug auf die y-Achse aufweist, der zwischen 91° und 179°, insbesondere zwischen 135° und 155° liegen kann. Somit ist bei dieser Ausführungsform ein unterer Abschnitt 22 der zweiten Ausnehmung 12 geneigt zur y-Achse angeordnet. Somit können insbesondere im unteren Bereich erzeugte Versetzungen 40 oder Querfacetten in tiefere Bereiche abgelenkt werden. Die Oberseite 7 und/oder die erste Wandfläche und/oder die zweite Wandfläche und/oder die zweite Bodenfläche 14 können mit einer Passivierungsschicht 44 bedeckt sein. Zudem kann die vierte Seitenfläche 6 der Laserdiode 1 spiegelsymmetrisch zur zweiten Seitenfläche 4 in Bezug auf die Mittenebene 37 ausgebildet sein.

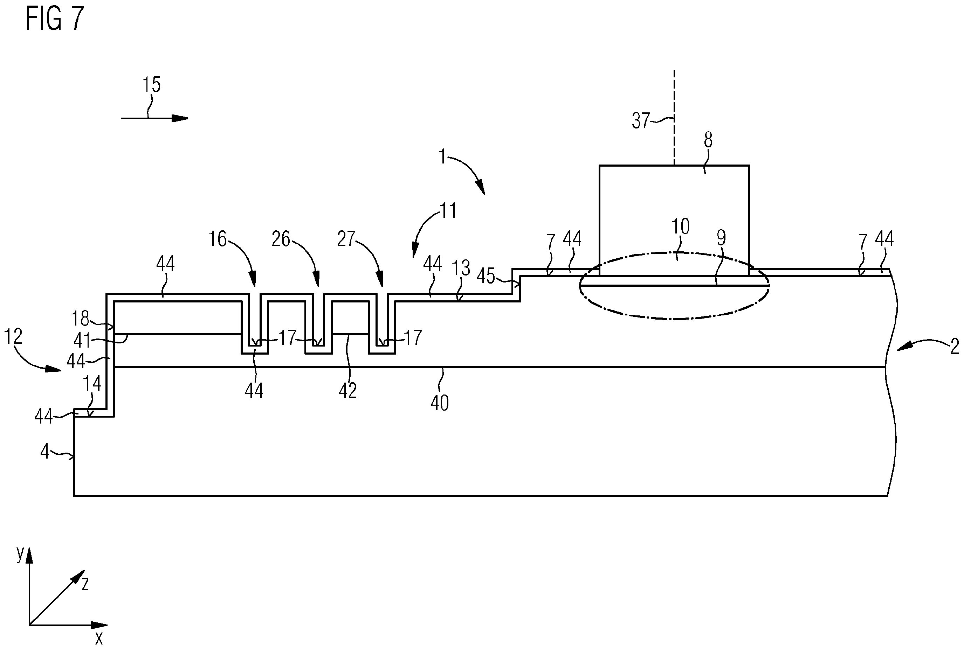

Fig. 7 zeigt einen Teilquerschnitt durch eine weitere Ausführungsform einer Laserdiode 1 in der Y-X Ebene, die im Wesentlichen der Ausführungsform der Fig. 3 entspricht, wobei jedoch zusätzlich eine vierte und eine fünfte Ausnehmung 26, 27 in die erste Bodenfläche 13 der ersten Ausnehmung 11 eingebracht sind. Abhängig von der gewählten Ausführungsform kann auf die fünfte Ausnehmung 27 verzichtet werden oder es können auch mehrere Ausnehmungen vorgesehen sein. Die vierte und die fünfte Ausnehmung 26, 27 können gemäß der dritten Ausnehmung 16 ausgebildet sein. Durch das Vorsehen der vierten und fünften Ausnehmung 26, 27 können weitere Querfacetten 41 abgefangen werden, die zwischen der dritten Ausnehmung 16 und der vierten bzw. zwischen der vierten und der fünften Ausnehmung 26,27 entstehen. Abhängig von der gewählten Ausführungsform können die Tiefen der dritten Ausnehmung 16 und der vierten und fünften Ausnehmung 26,27 unterschiedlich sein. Zudem können auch die Wandflächen der dritten Ausnehmung 16 und der vierten und fünften Ausnehmung 26,27 geneigt zur y-Achse angeordnet sein, wie anhand der Beispiele der Figuren 5 und 6 erläutert wurde.

Die Oberseite 7 und/oder die Wandfläche 18 der zweiten Ausnehmung 12 und/oder die zweite Bodenfläche 14 der zweiten Ausnehmung 12 und/oder die Wände und Bodenflächen der dritten und/oder der vierten und/oder der fünften Ausnehmung 16,26,27 können mit einer Passivierungsschicht 44 bedeckt sein. Zudem kann die vierte Seitenfläche 6 der Laserdiode 1 spiegelsymmetrisch zur zweiten Seitenfläche 4 in Bezug auf die Mittenebene 37 ausgebildet sein. Weiterhin kann auch die Oberseite 7, die zwischen der Ridgestruktur 8 und der vierten Seitenfläche 6 angeordnet ist, eine dritte, eine vierte und eine fünfte Ausnehmung aufweisen und spiegelsymmetrisch zur Mittenebene 37 ausgebildet sein.

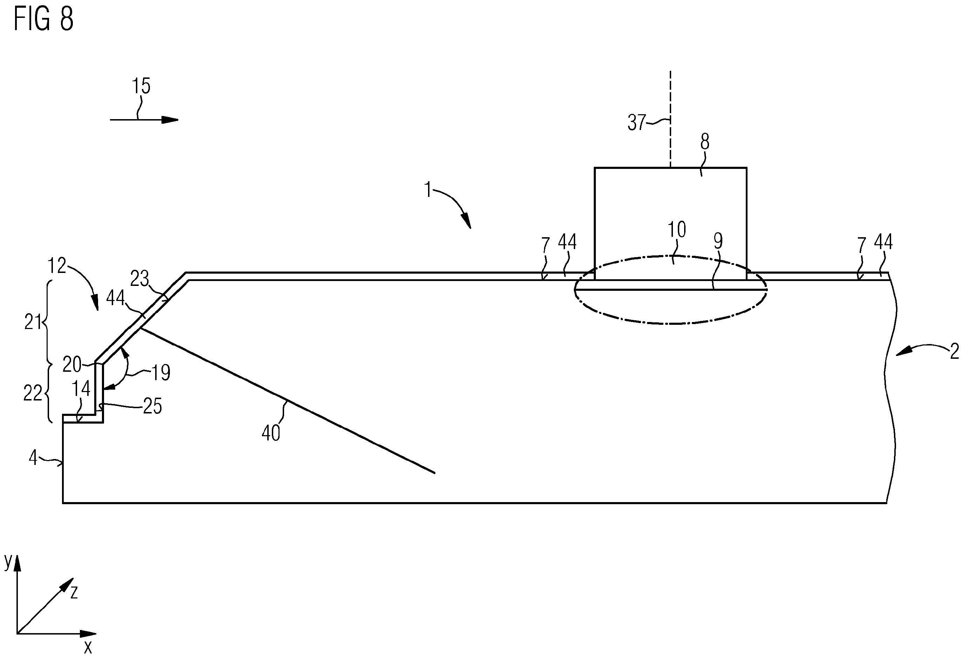

Fig. 8 zeigt einen Teilquerschnitt durch eine weitere Ausführungsform einer Laserdiode 1 in der Y-X Ebene mit einer zweiten Ausnehmung 12. Die zweite Ausnehmung 12 weist in einem oberen Abschnitt 21 eine erste Wandfläche 23 auf, die in einem Winkel 19 geneigt zur y-Achse angeordnet ist. Der Winkel 19 kann im Bereich zwischen 91° und 179°, insbesondere zwischen 135° und 155° liegen. Die erste Wandfläche 23 geht über eine Kante 20 in einen unteren Abschnitt 22 und eine zweite Wandfläche 25 über. Die Kante 20 ist parallel zur z-Achse insbesondere über die gesamte Länge der Laserdiode 1 geführt. Die zweite Wandfläche 25 ist parallel zur y-Achse angeordnet.

Die zweite Wandfläche 25 geht über eine zweite Bodenfläche 14 in Richtung der x-Achse in die zweite Seitenfläche 4 über. Somit wird bei dieser Ausführungsform durch die geneigt angeordnete erste Wandfläche 23 Störungen und Querfacetten 40, die beim Brechen entstehen können, nach unten außerhalb des Bereichs der Lasermode 10 abgelenkt. Die Oberseite 7 und/oder die erste und/oder die zweite Wandfläche 23,25 und/oder die zweite Bodenfläche 14 der zweiten Ausnehmung 12 können mit einer Passivierungsschicht 44 bedeckt sein. Zudem kann die vierte Seitenfläche 6 der Laserdiode 1 spiegelsymmetrisch zur zweiten Seitenfläche 4 in Bezug auf die Mittenebene 37 ausgebildet sein.

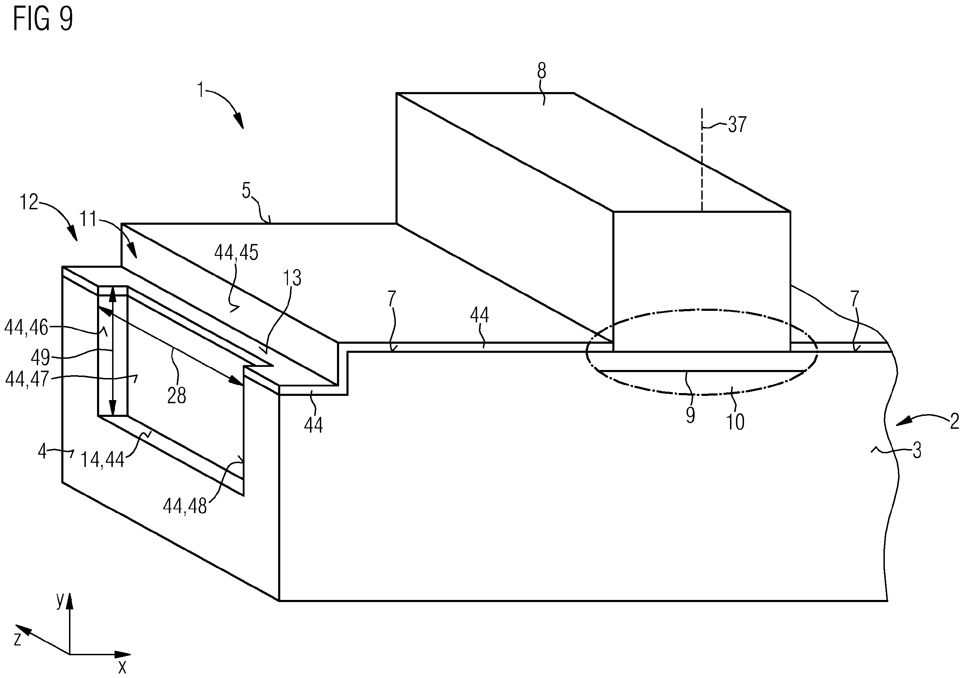

Fig. 9 zeigt in einer schematischen perspektivischen Darstellung einen Teilabschnitt einer weiteren Ausführungsform einer Laserdiode 1 mit Blick auf die erste Seitenfläche 3, wobei eine erste Ausnehmung 11 mit einer ersten Bodenfläche 13 in der Oberseite 7 ausgebildet ist. Die erste Ausnehmung 11 erstreckt sich in der Z-Richtung beispielsweise über die gesamte Länge der Laserdiode 1 oder nur über einen Teil der gesamten Länge der Laserdiode 1. Somit kann die erste Ausnehmung 11 in Form einer Abstufung ausgebildet sein. Die erste Ausnehmung 11 weist eine erste Wandfläche 45 und eine erste Bodenfläche 13 auf. Die erste Wandfläche 45 kann senkrecht zur Oberseite 7 angeordnet sein. Die erste Bodenfläche 13 kann parallel zur Oberseite 7 angeordnet sein. Die Wandfläche 45 und/oder die erste Bodenfläche 13 können mit einer Passivierungsschicht 44 bedeckt sein.

In die erste Bodenfläche 13 der ersten Ausnehmung 11 ist eine zweite Ausnehmung 12 eingebracht. Die zweite Ausnehmung 12 erstreckt sich in der x-Richtung bis zur zweiten Seitenfläche 4. Somit ist die zweite Ausnehmung 12 in der ersten Bodenfläche 13 und in der zweiten Seitenfläche 4 geöffnet. Die zweite Ausnehmung 12 weist drei weitere Wandflächen 46,47,48 und eine zweite Bodenfläche 14 auf. Die zweite Bodenfläche 14 ist z.B. parallel zur ersten Bodenfläche 13 angeordnet. Die erste Wandfläche 46 ist gegenüber der dritten Seitenfläche 5 nach innen versetzt angeordnet. Die erste Wandfläche 46 kann parallel zur dritten Seitenfläche 5 angeordnet sein. Die dritte Wandfläche 48 ist gegenüber der ersten Seitenfläche 3 nach innen versetzt angeordnet. Die dritte Wandfläche 48 kann parallel zur ersten Seitenfläche 3 angeordnet sein. Die drei weiteren Wandflächen 46,47,48 und die zweite Bodenfläche 14 können mit einer dünnen Passivierungsschicht 44 bedeckt sein, die die Form der zweiten Ausnehmung 12 nur unwesentlich ändert. Die zweite Ausnehmung 12 ist zwischen der ersten und der dritten Seitenfläche 3, 5 angeordnet und von der ersten und der dritten Seitenfläche 3, 5 in dem dargestellten Beispiel beabstandet. Die erste und die dritte Seitenfläche 3,5 stellen Facettenflächen dar.

Abhängig von der gewählten Ausführungsform kann sich die zweite Ausnehmung 12 auch bis zur ersten und dritten Seitenfläche 3,5 erstrecken und in Form einer zweiten Abstufung ausgebildet sein. Zudem kann die zweite Ausnehmung 12 auch nur im Bereich der ersten und der dritten Seitenfläche 3,5 angeordnet sein. Die erste Ausnehmung 11 weist in dieser Ausführungsform ausgehend von der Oberseite 7 eine Tiefe parallel zur Y-Achse zwischen 0,5 und 25 µm auf. Die zweite Ausnehmung 12 weist eine Tiefe 49 in Bezug zur ersten Bodenfläche 13 der ersten Ausnehmung 11 auf, die im Bereich zwischen 0,5 µm und 50 µm, beispielsweise zwischen 1 µm und 10 µm, insbesondere in einem Bereich zwischen 2 µm und 6 µm liegt. Die erste Bodenfläche 13 kann oberhalb oder unterhalb der aktiven Zone 9 angeordnet sein.

Abhängig von der gewählten Ausführungsform kann sich die Länge 28 der zweiten Ausnehmung 12 parallel zur z-Achse in einem Bereich zwischen 5% und 100% der gesamten Länge der Laserdiode 1 parallel zur z-Achse erstrecken. Bei einer Länge von 100 % weist die zweite Ausnehmung 12 nur eine zweite weitere Wandfläche 47 und eine zweite Bodenfläche 14 auf. Insbesondere kann sich die Länge 28 der zweiten Ausnehmung im Bereich zwischen 50% und 99% der Länge der Laserdiode 1 parallel zur z-Achse erstrecken. Zudem kann sich die Länge 28 der zweiten Ausnehmung 12 über einen Bereich zwischen 80% und 97% entlang der z-Achse der Laserdiode erstrecken. Die zweite Ausnehmung 12 kann symmetrisch und mittig in Bezug auf die Länge der Laserdiode in der z-Richtung angeordnet sein. Mithilfe dieser Ausführungsformen können Leckströme bei einer p-down Montage, bei der die Ridgestruktur 8 auf einem Träger montiert wird, aufgrund der ersten und zweiten Ausnehmungen 11,12 und/oder der Passivierungsschicht 44 reduziert werden. Zudem werden dadurch die Ausnehmungen 11,12 Versetzungen beim Brechen der ersten und/oder der dritten Seitenfläche 3, 5 reduziert. Zudem kann die vierte Seitenfläche 6 der Laserdiode 1 spiegelsymmetrisch zur zweiten Seitenfläche 4 in Bezug auf die Mittenebene 37 ausgebildet sein.

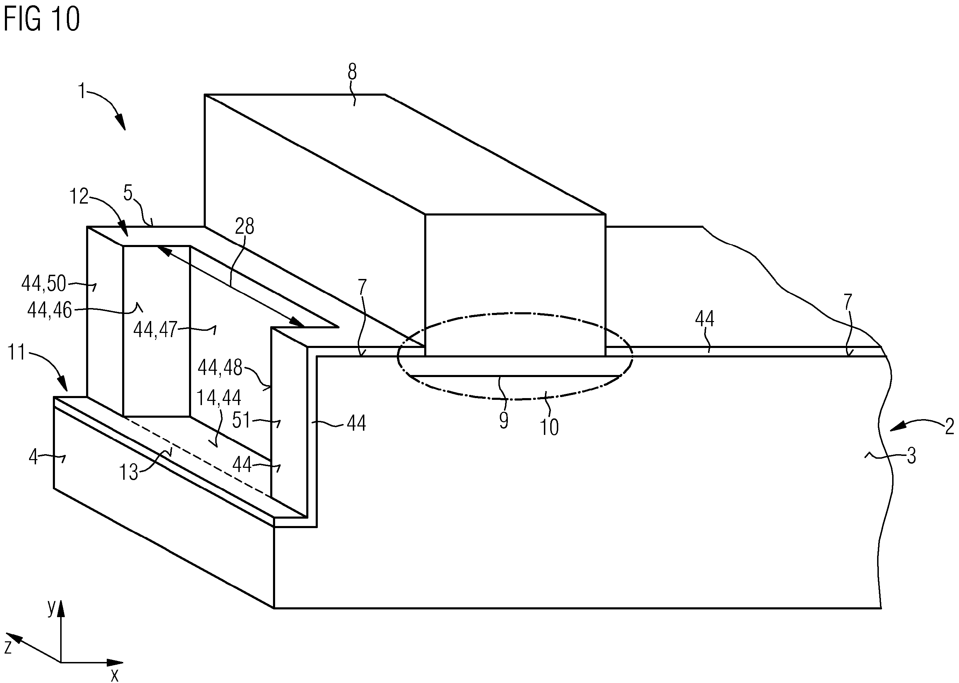

Fig. 10 zeigt eine perspektivische Teildarstellung einer weiteren Ausführungsform einer Laserdiode 1 mit Blick auf die erste Seitenfläche 3. In die Oberseite 7 ist eine erste Ausnehmung 11 eingebracht, die direkt an die zweite Seitenfläche 4 angrenzt und sich von der ersten Seitenfläche bis zur dritten Seitenfläche 3,5 erstreckt. Die erste Ausnehmung 11 weist eine erste Bodenfläche 13 auf, die z.B. parallel zur Oberseite 7 angeordnet ist. Zudem wird die erste Ausnehmung 11 durch zwei weitere sechste Wandflächen 50,51 begrenzt. Die zwei weiteren sechsten Wandflächen 50,51 stellen zudem nach innen zurückgesetzte Teile der zweiten Seitenfläche 4 dar. Somit bildet die erste Ausnehmung 11 eine seitliche Abstufung der ersten Seitenfläche 4 dar.

In die Oberseite 7 und in die erste Ausnehmung 11 ist eine zweite Ausnehmung 12 eingebracht. Eine Grenze zwischen der ersten Ausnehmung 11 und der zweiten Ausnehmung 12 ist gestrichelt auf der ersten Bodenfläche 13 dargestellt. Zudem grenzt die zweite Ausnehmung 12 an die weiteren Wandflächen 50,51 der zweiten Seitenfläche 4 an. Die zweite Ausnehmung 12 weist drei weitere Wandflächen 46,47,48 und eine zweite Bodenfläche 14 auf. Die zweite Ausnehmung 12 ist zwischen der ersten und der dritten Seitenfläche 3, 5 angeordnet und von der ersten und der dritten Seitenfläche 3, 5 beabstandet. Die erste Ausnehmung 11 und die zweite Ausnehmung 12 weisen in dieser Ausführung die gleiche Tiefe entlang der Y-Achse auf. Die zweite Ausnehmung 12 weist eine Tiefe in Bezug auf die Oberseite 7 auf, die im Bereich zwischen 0,5 µm und 50 µm, beispielsweise zwischen 1 µm und 10 µm, insbesondere in einem Bereich zwischen 2 µm und 6 µm liegt.

Abhängig von der gewählten Ausführungsform kann sich die Länge 28 der zweiten Ausnehmung 12 parallel zur z-Achse in einem Bereich zwischen 5% und 100% der gesamten Länge der Laserdiode 1 parallel zur z-Achse erstrecken. Die zweite Ausnehmung 12 kann mittig zu der Längserstreckung der Laserdiode 1 angeordnet sein. Bei einer Länge von 100 % weist die zweite Ausnehmung 12 nur eine zweite weitere Wandfläche 47 und eine zweite Bodenfläche 14 auf. Insbesondere kann sich die Länge 28 der zweiten Ausnehmung 12 im Bereich zwischen 50% und 99% der Länge der Laserdiode 1 parallel zur z-Achse erstrecken. Zudem kann sich die Länge 28 der zweiten Ausnehmung 12 über einen Bereich zwischen 80% und 97% entlang der z-Achse der Laserdiode erstrecken. Mithilfe dieser Ausführungsform können Leckströme bei einer p-down Montage, bei der die Ridgestruktur 8 auf einem Träger montiert wird, aufgrund der ersten und zweiten Ausnehmungen 11,12 und/oder der Passivierungsschicht 44 reduziert werden. Zudem werden dadurch die Ausnehmungen 11,12 Versetzungen beim Brechen der ersten und/oder der dritten Seitenfläche 3, 5 reduziert. Zudem kann die vierte Seitenfläche 6 der Laserdiode 1 spiegelsymmetrisch zur zweiten Seitenfläche 4 in Bezug auf die Mittenebene 37 ausgebildet sein und eine entsprechende erste und zweite Ausnehmung 11,12 aufweisen. Abhängig von der gewählten Ausführung können die erste und zweite Ausnehmung 11,12 der vierten Seite 6 auch andere Formen oder Dimensionen als die erste und die zweite Ausnehmung 11,12 der zweiten Seite 4 aufweisen.

Die drei weiteren Wandflächen 46,47,48 und die zweite Bodenfläche 14 der zweiten Ausnehmung 12 und die erste Bodenfläche 13 und die weiteren sechsten Wandflächen 50,51 können mit einer Passivierungsschicht 44 bedeckt sein.

Eine wenigstens teilweise passivierte zweite Seitenfläche 4, die lateral unterschiedliche Breiten aufweist, z.B. dünner im Bereich der ersten und dritten Seitenfläche ist, ermöglicht eine Kombination mit einer tiefen Mesastruktur mit zusätzlichen Ausnehmungen im Bereich der ersten und der dritten Seitenfläche 3, 5, auch wenn die aktive Zone 9 sehr nahe an einer Seitenfläche der Schichtstruktur sitzt und beispielsweise einen Abstand von kleiner als 50 µm bei einer asymmetrischen Ridgeposition aufweist. Dadurch können Leckströme bei einer p-down Montage, bei der die Ridgestruktur 8 auf einem Träger montiert wird, reduziert werden. Zudem können Querfacetten und/oder Störungen abgefangen werden. Zudem kann die vierte Seitenfläche 6 der Laserdiode 1 spiegelsymmetrisch zur zweiten Seitenfläche 4 in Bezug auf die Mittenebene 37 ausgebildet sein.

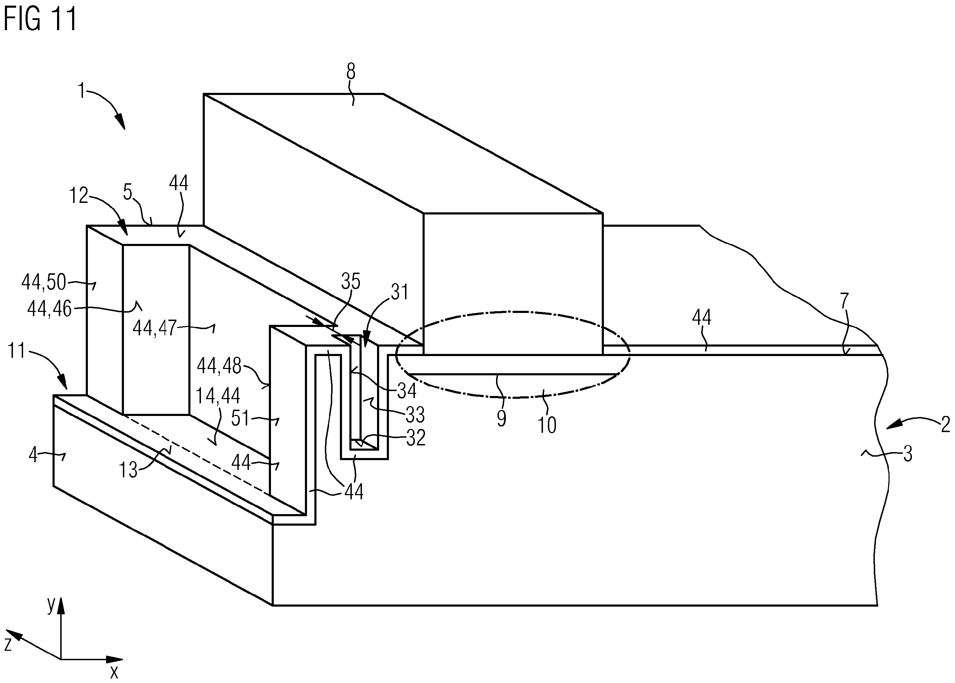

Fig. 11 zeigt eine Teildarstellung einer Ausführungsform einer Laserdiode 1 mit Blick auf die erste Seitenfläche 3, die im Wesentlichen der Ausführungsform der Fig. 10 entspricht. Dabei ist jedoch zusätzliche eine siebte Ausnehmung 31 vorgesehen, die im Bereich der ersten Seitenfläche 3 in die Oberseite 7 der Schichtstruktur 2 eingebracht ist. Die siebte Ausnehmung 31 weist eine siebte Bodenfläche 32 auf. Die siebte Bodenfläche 32 ist zwischen der Oberseite 7 und der zweiten Bodenfläche 14 der zweiten Ausnehmung 12 angeordnet. Zudem erstreckt sich die siebte Ausnehmung 31 in der x-Achse bis in einen Bereich, in dem seitlich in der Z-Achse versetzt auch die zweite Ausnehmung 12 ausgebildet ist. Die siebte Ausnehmung 31 bietet zusätzlich die Möglichkeit, Querfacetten und Störungen beim Brechen der Laserdiode 1 bzw. beim Brechen der ersten Seitenfläche 3 abzufangen. Abhängig von der gewählten Ausführungsform kann auch an der dritten Seitenfläche 5 eine siebte Ausnehmung 31 wie bei der ersten Seitenfläche 3 angeordnet sein.

Die zweite Ausnehmung 12 weist mit der Wandfläche 18 den gleichen oder einen kleineren oder größeren Abstand zur Ridgestruktur 8 auf wie die siebte Ausnehmung 31 mit einer siebten Wandfläche 33, die der Ridgestruktur 8 zugewandt ist bzw. parallel zur z-Achse ausgerichtet ist. Zudem weist die siebte Ausnehmung 31 eine weitere siebte Wandfläche 34 auf, die der siebten Wandfläche 33 gegenüberliegt. Die weitere siebte Wandfläche 34 weist einen größeren Abstand zur Ridgestruktur 8 auf als die Wandfläche 18 der zweiten Ausnehmung 12 auf. Die zweite und die siebte Ausnehmung 12, 31 weisen in der z-Richtung einen Abstand 35 voneinander auf. Die Flächen der siebten Ausnehmung 31 können mit einer Passivierungsschicht 44 bedeckt sein.

Auf der Oberseite 7 der Laserdiode 1 ist auf beiden Seiten der Ridgestruktur 8 eine Isolationsschicht aufgebracht, so dass ein Stromfluss auf den Bereich der Ridgestruktur 8 begrenzt ist. Zudem sind die zweite und vierte Seitenfläche 4,6 und auch die Ausnehmungen mit einer Passivierungsschicht 44 bedeckt. Die drei weiteren Wandflächen 46,47,48 und die zweite Bodenfläche 14 der zweiten Ausnehmung 12 und die erste Bodenfläche 13 und die weiteren sechsten Wandflächen 50,51 können mit einer Passivierungsschicht 44 bedeckt sein. Die Passivierungsschicht 44 wird z.B. mithilfe einer chemischen Umwandlung, insbesondere durch eine Oxidation des Materials der Seitenflächen erzeugt. Die Seitenflächen 4,6 sind beispielsweise aus Silizium, wobei die Passivierungsschicht aus Siliziumoxid besteht.

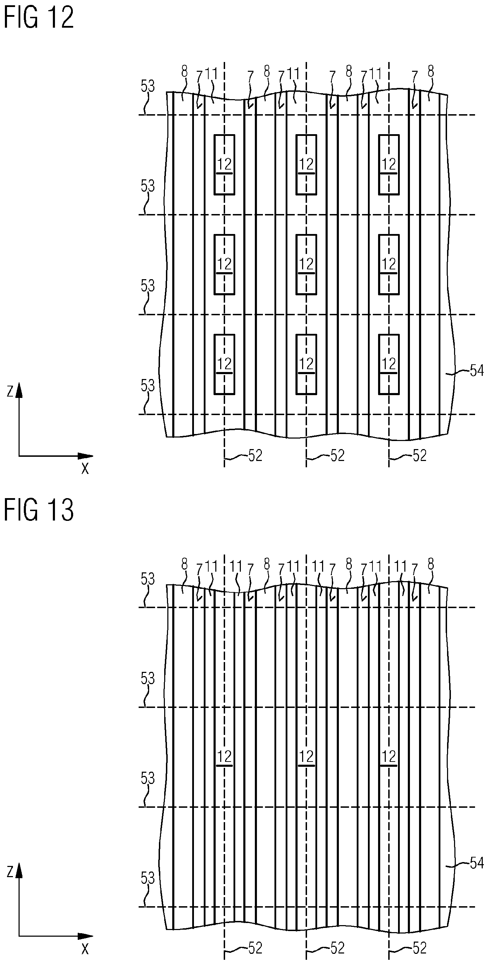

Fig. 12 zeigt eine schematische Draufsicht auf einen Teil eines Wafers 54 mit Bauelementen gemäß Fig. 9 vor dem Vereinzeln der Bauelemente. Dabei sind erste Trennlinien 52 und zweite Trennlinien 53 als gestrichelte Linien dargestellt. Die ersten Trennlinien 52 verlaufen parallel zu den streifenförmigen Ridgestrukturen 8. Die zweiten Trennlinien 53 verlaufen senkrecht zu den Ridgestrukturen 8.
Die ersten Ausnehmungen 11 sind als parallele Streifen ausgebildet. Die zweiten Ausnehmungen 12 sind als Streifen ausgebildet, die in parallelen Linien angeordnet sind. Es sind erste Trennlinien 52 und zweite Trennlinien 53 als gestrichelte Linien dargestellt. Die ersten Trennlinien 52 verlaufen parallel zu den streifenförmigen Ridgestrukturen 8 mitten durch die ersten und die zweiten Ausnehmungen 11,12. Die zweiten Trennlinien 53 verlaufen senkrecht zu den Ridgestrukturen 8 jeweils zwischen zwei zweiten Ausnehmungen 12. Die zweiten Trennlinien 53 definieren die erste und die dritte Seitenfläche eines Bauelementes. Die ersten Trennlinien 52 definieren die zweiten und die vierten Seitenflächen der Bauelemente. Die Bauelemente werden gemäß den Trennlinien 52,53 vereinzelt. Dabei wird der Wafer 54 entlang der zweiten Trennlinien 53 gebrochen. Entlang der ersten Trennlinien 52 kann der Wafer 54 ebenfalls gebrochen werden. Bei der dargestellten Ausführungsform erstreckt sich die erste Ausnehmung 11 über eine gesamte Länge eines Bauelementes. Bei der dargestellten Ausführungsform erstreckt sich die zweite Ausnehmung 12 nur über einen Teil der Länge eines Bauelementes.

Fig. 13 zeigt eine schematische Draufsicht auf einen Teil eines Wafers 54 mit einer weiteren Ausführungsform von Bauelementen vor dem Vereinzeln der Bauelemente. Dabei sind erste Trennlinien 52 und zweite Trennlinien 53 als gestrichelte Linien dargestellt. Die ersten Trennlinien 52 verlaufen parallel zu den streifenförmigen Ridgestrukturen 8. Die zweiten Trennlinien 53 verlaufen senkrecht zu den Ridgestrukturen 8.

Die ersten Ausnehmungen 11 sind als parallele Streifen ausgebildet. Die zweiten Ausnehmungen 12 sind als parallele Streifen ausgebildet. Es sind erste Trennlinien 52 und zweite Trennlinien 53 als gestrichelte Linien dargestellt. Die ersten Trennlinien 52 verlaufen parallel zu den streifenförmigen Ridgestrukturen 8 mitten durch die zweiten Ausnehmungen 12. Die zweiten Trennlinien 53 verlaufen senkrecht zu den Ridgestrukturen 8 jeweils zwischen zwei zweiten Ausnehmungen 12.

Die zweiten Trennlinien 53 definieren die erste und die dritte Seitenfläche eines Bauelementes. Die ersten Trennlinien 52 definieren die zweiten und die vierten Seitenflächen der Bauelemente. Die Bauelemente werden gemäß den Trennlinien 52,53 vereinzelt. Dabei wird der Wafer 54 entlang der zweiten Trennlinien 53 gebrochen. Entlang der ersten Trennlinien 52 kann der Wafer 54 ebenfalls gebrochen werden. Die Bauelemente sind im Wesentlichen gemäß Fig. 12 ausgebildet, wobei jedoch in dieser Ausführungsform sich die zweiten Ausnehmungen 12 über die gesamte Länge der Bauelemente erstrecken.

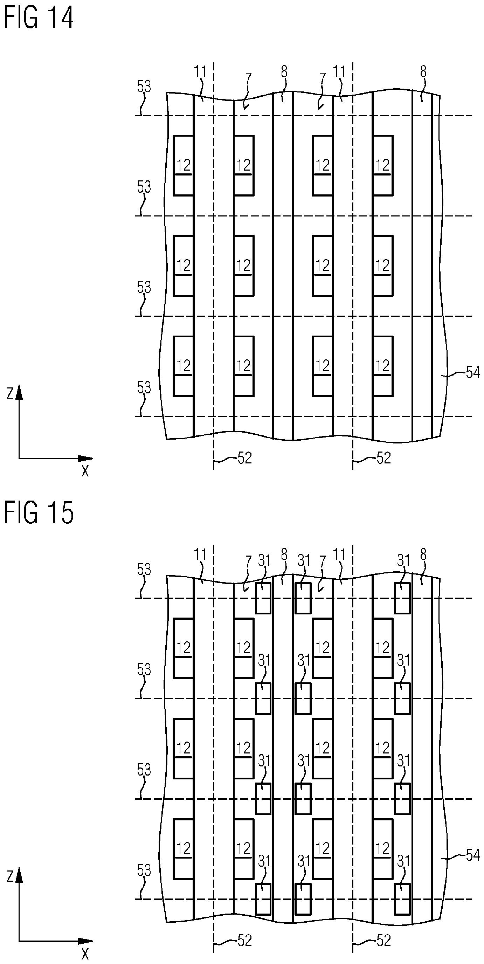

Fig. 14 zeigt eine schematische Draufsicht auf einen Teil eines Wafers 54 mit Bauelementen gemäß Fig. 10 vor dem Vereinzeln der Bauelemente. Die Ridgestrukturen 8 sind parallel zueinander angeordnet.

Die ersten Ausnehmungen 11 sind als parallele Streifen ausgebildet. Die zweiten Ausnehmungen 12 sind als Streifen ausgebildet, die in parallelen Linien angeordnet sind. Es sind erste Trennlinien 52 und zweite Trennlinien 53 als gestrichelte Linien dargestellt. Die ersten Trennlinien 52 verlaufen parallel zu den streifenförmigen Ridgestrukturen 8 mitten durch die ersten Ausnehmungen 11. Die zweiten Trennlinien 53 verlaufen senkrecht zu den Ridgestrukturen 8 jeweils zwischen zwei zweiten Ausnehmungen 12.

Die zweiten Trennlinien 53 definieren die erste und die dritte Seitenfläche eines Bauelementes. Die ersten Trennlinien 52 definieren die zweiten und die vierten Seitenflächen der Bauelemente. Die Bauelemente werden gemäß den Trennlinien 52,53 vereinzelt. Dabei wird der Wafer 54 entlang der zweiten Trennlinien 53 gebrochen. Entlang der ersten Trennlinien 52 kann der Wafer 54 ebenfalls gebrochen werden. Die ersten Ausnehmungen 11 erstrecken sich über die gesamte Länge der Bauelemente. Die zweiten Ausnehmungen 12 erstrecken sich nur über einen Teil der Länge der Bauelemente.

Fig. 15 zeigt eine schematische Draufsicht auf einen Teil eines Wafers 54 mit Bauelementen gemäß Fig. 11 vor dem Vereinzeln der Bauelemente. Die Anordnung ist wie in Fig. 14, wobei zusätzlich noch siebte Ausnehmungen 31 vorgesehen sind. Die Ridgestrukturen 8 sind parallel zueinander angeordnet. Dabei sind erste Trennlinien 52 und zweite Trennlinien 53 als gestrichelte Linien dargestellt. Die ersten Ausnehmungen 11 sind als parallele Streifen ausgebildet. Die zweiten Ausnehmungen 12 sind als Streifen ausgebildet, die in parallelen Linien angeordnet sind. Es sind erste Trennlinien 52 und zweite Trennlinien 53 als gestrichelte Linien dargestellt. Die ersten Trennlinien 52 verlaufen parallel zu den streifenförmigen Ridgestrukturen 8 mitten durch die ersten Ausnehmungen 11. Die zweiten Trennlinien 53 verlaufen senkrecht zu den Ridgestrukturen 8 jeweils zwischen zwei zweiten Ausnehmungen 12 und mittig durch siebte Ausnehmungen 31.

Die zweiten Trennlinien 53 definieren die erste und die dritte Seitenfläche eines Bauelementes. Die ersten Trennlinien 52 definieren die zweiten und die vierten Seitenflächen der Bauelemente. Die Bauelemente werden gemäß den Trennlinien 52,53 vereinzelt. Dabei wird der Wafer 54 entlang der zweiten Trennlinien 53 gebrochen. Entlang der ersten Trennlinien 52 kann der Wafer 54 ebenfalls gebrochen werden. Die siebten Ausnehmungen 31 sind auf den zweiten Trennlinien 53 angeordnet.

Die Erfindung ist ausschließlich durch die beigefügten Patentansprüche definiert.

### BEZUGSZEICHENLISTE

- 1: Laserdiode
- 2: Schichtstruktur
- 3: erste Seitenfläche
- 4: zweite Seitenfläche
- 5: dritte Seitenfläche
- 6: vierte Seitenfläche
- 7: Oberseite
- 8: Ridgestruktur
- 9: aktive Zone
- 10: Lasermode
- 11: erste Ausnehmung
- 12: zweite Ausnehmung
- 13: erste Bodenfläche
- 14: zweite Bodenfläche
- 15: Bruchrichtung
- 16: dritte Ausnehmung
- 17: dritte Bodenfläche
- 18: Wandfläche
- 19: Winkel
- 20: Kante
- 21: oberer Abschnitt
- 22: unterer Abschnitt
- 23: erste Wandfläche
- 24: zweite Bodenfläche
- 25: zweite Wandfläche
- 26: vierte Ausnehmung
- 27: fünfte Ausnehmung
- 28: Länge
- 31: siebte Ausnehmung
- 32: siebte Bodenfläche
- 33: siebte Wandfläche
- 34: weitere siebte Wandfläche
- 35: Abstand
- 36: Träger
- 37: Mittenebene

- 40: Versetzung
- 41: 2. Versetzung
- 42: 3. Versetzung
- 44: Passivierungsschicht
- 45: Wandfläche
- 46: 1.weitere Wandfläche
- 47: 2. Weitere Wandfläche
- 48: 3. Weitere Wandfläche
- 49: Tiefe
- 50: Weitere sechste Wandfläche
- 51: Weitere sechste Wandfläche
- 52: erste Trennlinie
- 53: zweite Trennlinie
- 54: Wafer

## Patentansprüche

1. Optoelektronisches Bauelement, wobei das optoelektroische Bauelement eine Laserdiode ist, mit einer Schichtstruktur (2) mit einer aktiven Zone (9) zum Erzeugen einer elektromagnetischen Strahlung, wobei die aktive Zone (9) in einer Ebene angeordnet ist, wobei die Schichtstruktur (2) eine Oberseite (7) und vier Seitenflächen (3, 4, 5, 6) aufweist, wobei die erste und die dritte Seitenfläche (3,5) gegenüber liegend angeordnet sind, wobei die zweite und die vierte Seitenfläche (4, 6) gegenüber liegend angeordnet sind, wobei eine streifenförmige Ridgestruktur (8) auf der Oberseite (7) der Schichtstruktur (2) angeordnet ist, wobei sich die Ridgestruktur (8) zwischen der ersten Seitenfläche (3) und der dritten Seitenfläche (5) erstreckt, wobei die erste Seitenfläche (3) eine Abstrahlfläche für elektromagnetische Strahlung darstellt, wobei seitlich neben der Ridgestruktur (8) in die Oberseite (7) der Schichtstruktur (2) eine erste Ausnehmung (11) eingebracht ist, wobei eine zweite Ausnehmung (12) in die erste Ausnehmung (11) eingebracht ist, und wobei sich die zweite Ausnehmung (12) bis zu der zweiten Seitenfläche (4,50,51) erstreckt, wobei die zweite Ausnehmung (12) in eine erste Bodenfläche (13) der ersten Ausnehmung (11) eingebracht ist, wobei sich die zweite Ausnehmung (12) entlang der zweiten Seitenfläche (4) erstreckt, wobei die zweite Ausnehmung (12) beabstandet von der ersten Seitenfläche (3) und beabstandet von der dritten Seitenfläche (5) ausgebildet ist, und wobei die zweite Ausnehmung (12) in die zweite Seitenfläche (4) mündet, **dadurch gekennzeichnet dass** sich die erste Ausnehmung (11) über eine gesamte Länge der Laserdiode (1) von der ersten bis zur dritten Seitenfläche (3, 5) entlang der zweiten Seitenfläche (4) erstreckt, wobei sich die erste Ausnehmung (11) bis zu der zweiten Seitenfläche (4) erstreckt.

2. Bauelement nach Anspruch 1, wobei die erste Ausnehmung (11) in die erste Seitenfläche (3) und/oder in die dritte Seitenfläche (5) eingebracht ist, und wobei die zweite Ausnehmung (12) in die erste Seitenfläche (3) und/oder in die dritte Seitenfläche (5) eingebracht ist.

3. Bauelement nach Anspruch 1 oder 2, wobei wenigstens eine dritte Ausnehmung (16) seitlich neben der Ridgestruktur (8) in eine Bodenfläche (13) der ersten Ausnehmung (11) eingebracht ist.

4. Bauelement nach Anspruch 3, wobei die dritte Ausnehmung (16) in die erste und/oder in die dritte Seitenfläche (3, 5) eingebracht ist.

5. Bauelement nach Anspruch 3, wobei die dritte Ausnehmung (16) im Wesentlichen parallel zu der zweiten Seitenfläche (4) angeordnet ist, wobei die dritte Ausnehmung (16) beabstandet zu der ersten Seitenfläche (3) und beabstandet zu der dritten Seitenfläche (5) angeordnet ist.

6. Bauelement nach einem der Ansprüche 1 bis 5, wobei sich die zweite Ausnehmung (12) über einen Bereich von 1% bis 99% einer Längsseite einer zweiten Seitenfläche (4) erstreckt.

7. Bauelement nach einem der Ansprüche 3 bis 6, wobei die zweite Ausnehmung (12) eine größere Tiefe (48) bezogen auf eine Bodenfläche (13) der ersten Ausnehmung (11) als die dritte Ausnehmung (16) aufweist.

8. Bauelement nach einem der vorhergehenden Ansprüche, wobei die zweite Ausnehmung (12) eine Tiefe (48) im Bereich zwischen 0,5 µm und 50 µm, insbesondere im Bereich zwischen 1µm und 10µm bezogen auf die Oberseite (7) aufweist.

9. Bauelement nach Anspruch 8, wobei die zweite Ausnehmung (12) eine Tiefe (48) im Bereich zwischen 2 µm und 6 µm bezogen auf die Oberseite (7) aufweist.

10. Bauelement nach einem der vorhergehenden Ansprüche, wobei die zweite Seitenfläche (4) und die vierte Seitenfläche (6) auf beiden Seiten, insbesondere spiegelsymmetrisch in Bezug auf eine Mittenebene (37) ausgebildet sind, und/oder wobei die auf gegenüber liegenden Seiten bezüglich der Ridgestruktur (8) angeordneten Oberseiten (7) insbesondere spiegelsymmetrisch in Bezug auf die Mittenebene (37) ausgebildet sind.

## Claims

1. Optoelectronic component, wherein the optoelectronic component is a laser diode, with a layer structure (2) with an active zone (9) for producing electromagnetic radiation, wherein the active zone (9) is arranged in one plane , wherein the layer structure (2) comprises an upper side (7) and four side faces (3, 4, 5, 6), wherein the first and the third side face (3, 5) are arranged to lie opposite each other, wherein the second and the fourth side face (4, 6) are arranged to lie opposite each other, wherein a stripe-type ridge structure (8) is disposed on the upper side (7) of the layer structure (2), wherein the ridge structure (8) extends between the first side face (3) and the third side face (5), wherein the first side face (3) represents a radiation surface for electromagnetic radiation, wherein a first recess (11) is introduced, laterally next to the ridge structure (8), into the upper side (7) of the layer structure (2), wherein a second recess (12) is introduced into the first recess (11), and wherein the second recess (12) extends to the second side face (4, 50, 51), wherein the second recess (12) is introduced into a first bottom face (13) of the first recess (11), wherein the second recess (12) extends along the second side face (4), wherein the second recess (12) is formed at a distance from the first side face (3) and at a distance from the third side face (5), and wherein the second recess (12) opens into the second side face (4), **characterized in that** the first recess (11) extends over an entire length of the laser diode (1) along the second side face (4) from the first to the third side face (3, 5), wherein the first recess (11) extends up to the second side face (4).

2. Component according to Claim 1, wherein the first recess (11) is introduced into the first side face (3) and/or into the third side face (5), and wherein the second recess (12) is introduced into the first side face (3) and/or into the third side face (5).

3. Component according to Claim 1 or 2, wherein at least one third recess (16) is introduced into a bottom face (13) of the first recess (11) laterally next to the ridge structure (8).

4. Component according to Claim 3, wherein the third recess (16) is introduced into the first and/or into the third side face (3, 5).

5. Component according to Claim 3, wherein the third recess (16) is arranged substantially parallel to the second side face (4), wherein the third recess (16) is arranged at a distance from the first side face (3) and at a distance from the third side face (5).

6. Component according to any one of Claims 1 to 5, wherein the second recess (12) extends over a region of 1% to 99% of a longitudinal side of a second side face (4) .

7. Component according to any one of Claims 3 to 6, wherein the second recess (12) comprises a greater depth (48) with respect to a bottom surface (13) of the first recess (11) than the third recess (16).

8. Component according to any one of the preceding claims, wherein the second recess (12) comprises a depth (48) in the range between 0.5 µm and 50 µm, in particular in the range between 1 µm and 10 µm, with respect to the upper side (7).

9. Component according to Claim 8, wherein the second recess (12) comprises a depth (48) in the range between 2 µm and 6 µm with respect to the upper side (7).

10. Component according to any one of the preceding claims, wherein the second side face (4) and the fourth side face (6) are formed on both sides, in particular mirror-symmetrically with respect to a centre plane (37), and/or wherein the upper sides (7) which are arranged on opposite sides with respect to the ridge structure (8) are formed in particular mirror-symmetrically with respect to the centre plane (37).

## Revendications

1. Composant optoélectronique, le composant optoélectronique étant une diode laser, comportant une structure stratifiée (2) dotée d'une zone active (9) servant à générer un rayonnement électromagnétique, la zone active (9) étant disposée dans un plan, la structure stratifiée (2) présentant un côté supérieur (7) et quatre surfaces latérales (3, 4, 5, 6), la première et la troisième surface latérale (3, 5) étant disposées en regard, la deuxième et la quatrième surface latérale (4, 6) étant disposées en regard, une structure de crête (8) en forme de bande étant disposée sur le côté supérieur (7) de la structure stratifiée (2), la structure de crête (8) s'étendant entre la première surface latérale (3) et la troisième surface latérale (5), la première surface latérale (3) constituant une surface de rayonnement pour le rayonnement électromagnétique, un premier évidement (11) étant ménagé latéralement près de la structure de crête (8) dans le côté supérieur (7) de la structure stratifiée (2), un deuxième évidement (12) étant ménagé dans le premier évidement (11), et le deuxième évidement (12) s'étendant jusqu'à la deuxième surface latérale (4, 50, 51), le deuxième évidement (12) étant ménagé dans une première surface de base (13) du premier évidement (11), le deuxième évidement (12) s'étendant le long de la deuxième surface latérale (4), le deuxième évidement (12) étant réalisé de manière espacée de la première surface latérale (3) et de manière espacée de la troisième surface latérale (5), et le deuxième évidement (12) débouchant dans la deuxième surface latérale (4), **caractérisé en ce que** le premier évidement (11) s'étend sur une longueur totale de la diode laser (1) à partir de la première jusqu'à la troisième surface latérale (3, 5) le long de la deuxième surface latérale (4), le premier évidement (11) s'étendant jusqu'à la deuxième surface latérale (4).

2. Composant selon la revendication 1, le premier évidement (11) étant ménagé dans la première surface latérale (3) et/ou dans la troisième surface latérale (5), et le deuxième évidement (12) étant ménagé dans la première surface latérale (3) et/ou dans la troisième surface latérale (5).

3. Composant selon la revendication 1 ou 2, au moins un troisième évidement (16) étant ménagé latéralement près de la structure de crête (8) dans une surface de base (13) du premier évidement (11).

4. Composant selon la revendication 3, le troisième évidement (16) étant ménagé dans la première et/ou dans la troisième surface latérale (3, 5).

5. Composant selon la revendication 3, le troisième évidement (16) étant disposé sensiblement parallèlement à la deuxième surface latérale (4), le troisième évidement (16) étant réalisé de manière espacée de la première surface latérale (3) et de manière espacée de la troisième surface latérale (5).

6. Composant selon l'une des revendications 1 à 5, le deuxième évidement (12) s'étendant sur une plage de 1 % à 99 % d'un côté longitudinal d'une deuxième surface latérale (4).

7. Composant selon l'une des revendications 3 à 6, le deuxième évidement (12) présentant une plus grande profondeur (48) par rapport à une surface de base (13) du premier évidement (11) que le troisième évidement (16) .

8. Composant selon l'une des revendications précédentes, le deuxième évidement (12) présentant une profondeur (48) dans la plage entre 0,5 µm et 50 µm, en particulier dans la plage entre 1 µm et 10 µm par rapport au côté supérieur (7).

9. Composant selon la revendication 8, le deuxième évidement (12) présentant une profondeur (48) dans la plage entre 2 µm et 6 µm par rapport au côté supérieur (7) .

10. Composant selon l'une des revendications précédentes, la deuxième surface latérale (4) et la quatrième surface latérale (6) étant réalisées des deux côtés, en particulier en symétrie miroir par rapport à un plan médian (37), et/ou les côtés supérieurs (7) disposés sur des côtés opposés par rapport à la structure de crête (8) étant réalisés en particulier en symétrie miroir par rapport au plan médian (37).
